(19) Europäisches Patentamt
European Patent Office
Office européen des brevets

(11) **EP 3 282 582 A1**

(12) **EUROPEAN PATENT APPLICATION**

(43) Date of publication:
**14.02.2018 Bulletin 2018/07**

(51) Int Cl.:
**H03G 5/16** (2006.01)　　**H03G 9/14** (2006.01)
**H04R 5/04** (2006.01)

(21) Application number: **17184537.3**

(22) Date of filing: **02.08.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **08.08.2016　JP 2016155522**

(71) Applicant: **Onkyo Corporation**
**Osaka 572-0028 (JP)**

(72) Inventor: **TACHIMORI, Nobuya**
**Osaka, Osaka 572-0028 (JP)**

(74) Representative: **Horn Kleimann Waitzhofer**
**Patentanwälte PartG mbB**
**Ganghoferstrasse 29a**
**80339 München (DE)**

(54) **EQUALIZER DEVICE AND EQUALIZER PROGRAM**

(57)　　Problem: To perform amendment processing based on output level.

　　Solution: A DAP 1 includes a DSP 8. The DSP 8 calculates amendment value based on threshold and effective value of gain in case that the effective value of gain of equalizer information is not less than predetermined threshold, calculates amendment equalizer filter that the equalizer filter is amended based on the amendment value, and changes frequency characteristics of an audio signal based on the amendment equalizer filter. The DSP 8 changes the threshold based on volume.

**FIG. 3**

**Description**

TECHNICAL FIELD

The present invention relates to an equalizer device and an equalizer program that perform equalizer processing that changes frequency characteristics of an audio signal.

BACKGROUND ART

An equalizer device performs equalizer processing based on an equalizer filter (equalizer information) that indicates gain against frequency (for example, see patent literature 1). For example, the equalizer device stores equalizer filters according to genres such as rock, pops and jazz. A user can select the equalizer filter according to a genre.
To protect the sense of hearing from sound pressure that is reproduced from a headphone (including a so-called earphone), sound pressure regulation against portable audio devices is performed in Europe mainly. In case sound pressure that is output from the headphone is measured, it is necessary that an audio signal on which equalizer processing is performed is measured.
Applicant files JP 2016-076539 at April 6, 2016 in Japan. In JP 2016-076539, in case that effective value of gain of the equalizer filter is not less than a predetermined threshold, amendment value is calculated based on threshold and effective value of gain. And, the equalizer filter is amended based on amendment value that is calculated.

PRIOR ART DOCUMENT

PATENT LITERATURE

PATENT LITERATURE 1: JP 2012-084949 A

SUMMARY OF THE INVENTION

PROBLEM TO BE RESOLVED BY THE INVENTION

However, in JP 2016-076539, in case that output level is much smaller than sound pressure regulation, there is a problem that amendment processing is always performed.
An objective of the present invention is to perform amendment processing based on output level.

MEANS FOR SOLVING THE PROBLEM

An equalizer device of a first invention comprising: a signal processor configured to calculate amendment value based on threshold and effective value in case that the effective value of gain of equalizer information is not less than predetermined threshold, calculate amendment equalizer information that the equalizer information is amended based on the amendment value, and change frequency characteristics of an audio signal based on the amendment equalizer information, wherein the signal processor changes the threshold based on volume.
In the present invention, a signal processor changes threshold based on volume. Thus, amendment processing can be performed based on output level because amendment of equalizer information is not performed when volume is small.
The equalizer device of a second invention is the equalizer device of the first invention, wherein the signal processor multiplies the equalizer information by a test signal as a weight function, calculates first effective value that is effective value of frequency characteristics of the equalizer information multiplied by the test signal, calculates second effective value that is effective value of frequency characteristics of the test signal, and calculates third effective value that is effective value of gain of the equalizer information based on the first effective value and the second effective value.
In the present invention, the signal processor multiplies equalizer information by a test signal as a weight function, and calculates amendment value using the equalizer information multiplied by the test signal. And, the signal processor calculates amendment equalizer information that the equalizer information is amended based on the amendment value. Like this, an audio signal that is not more than regulation can be output by the amendment equalizer information that is amended because the test signal is considered and the equalizer information is amended using the equalizer information that frequency characteristics of the test signal is multiplied as the weight function even if the test signal is input.
The equalizer device of a third invention is the equalizer device of the second invention, wherein the signal processor calculates the amendment value by dividing the threshold by the third effective value.

The equalizer device of a fourth invention is the equalizer device of the second or the third invention, wherein the signal processor calculates the third effective value by dividing the first effective value by the second effective value.

The equalizer device of a fifth invention is the equalizer device of any one of the second to the fourth inventions, wherein the signal processor calculates the amendment equalizer information by multiplying the equalizer information by the amendment value.

The equalizer device of a sixth invention is the equalizer device of any one of the second to the fifth inventions, wherein the signal processor calculates the first effective value by taking the square root of sum of value of each frequency of product of the equalizer information multiplied by the test signal and conjugate complex number of the equalizer information multiplied by the test signal.

The equalizer device of a seventh invention is the equalizer invention of the second to the sixth inventions, wherein the signal processor calculates the first effective value by taking the square root of sum of value of each frequency of product of the equalizer information multiplied by the test signal and conjugate complex number of the equalizer information multiplied by the test signal.

The equalizer device of an eighth invention is the equalizer invention of any one of the second to the seventh invention, wherein the test signal is Programme Simulation Noise.

The equalizer device according of a ninth invention is the equalizer device of any one of the second to the eighth inventions further comprising, a controller that receives setting of parameter of the equalizer information, wherein the signal processor generates the equalizer information by interpolating the parameter that the controller receives.

An equalizer program of a tenth invention allows a signal processor of a computer to calculate amendment value based on threshold and effective value in case that the effective value of gain of equalizer information is not less than predetermined threshold, to calculate amendment equalizer information that the equalizer information is amended based on the amendment value, and to change frequency characteristics of an audio signal based on the amendment equalizer information, and to change the threshold based on volume.

EFFECT OF THE INVENTION

According to the present invention, amendment processing can be performed based on output level.

BRIEF DESCRIPTION OF THE DRAWINGS

Fig. 1 is a block diagram illustrating a constitution of a DAP to according to an embodiment of the present invention.
Fig. 2 is a diagram illustrating a constitution of application of the DAP.
Fig. 3 is a flow chart illustrating processing operation of the DAP in case where volume value is changed.
Fig. 4 is a flow chart illustrating processing operation in case where the DAP generates an amendment equalizer filter that an equalizer filter is amended.
Fig. 5 is a diagram illustrating parameter that setting is received.
Fig. 6 is a diagram illustrating the equalizer filter.
Fig. 7 is a diagram illustrating the equalizer filter that a weight function is multiplied.
Fig. 8 is a diagram illustrating one example of the equalizer filter.
Fig. 9 is a diagram illustrating effective value of output voltage of a headphone terminal.

DESCRIPTION OF THE EMBODIMENTS

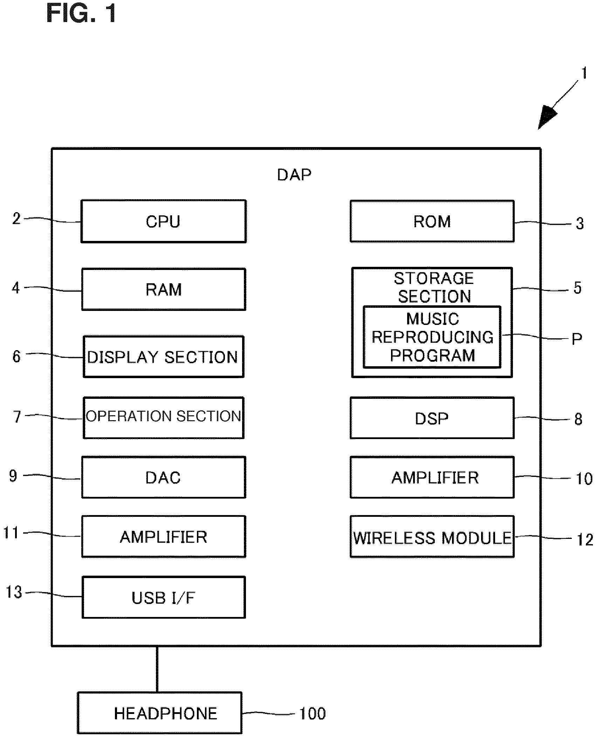

An embodiment of the present invention is described below. Fig. 1 is a block diagram illustrating a constitution of a digital audio player (hereinafter, referred as to "DAP") according to an embodiment of the present invention. A DAP 1 functions as an equalizer device that changes frequency characteristics of the audio signal by executing a music reproducing program P (equalizer program) that is stored in a storage section 5. As illustrated in Fig. 1, the DAP 1 includes a CPU (Central Processing Unit)2, a ROM (Read Only Memory) 3, a RAM (Random Access Memory) 4, the storage section 5, a display section 6, an operation section 7, a DSP (Digital Signal Processor) 8, a D/A converter (hereinafter, referred as to "DAC") 9, amplifiers 10 and 11, a wireless module 12, and a USB interface (hereinafter, referred as to "USB I/F") 13.

The CPU 2 (controller) controls respective sections composing the DAP 1 according to a control program, an OS program or application programs including the music reproducing program P. The ROM 3 stores the control program. The RAM 4 functions as a main memory of the CPU 2. The storage section 5 is a flash memory that stores programs such as the OS program and the application programs including the music reproducing program P and various data such as digital audio data. The storage section 5 is not limited to the illustrated constitution, and may be an HDD (Hard Disk Drive).

The display section 6 displays various images (including still images and moving images), and is composed of a liquid crystal panel. The operation section 7 has operation keys for performing various settings, and a touch panel that is linked with the display section 6. A user can input various characters and perform setting via the operation section 7. Further, the user can set parameter of an equalizer filter (equalizer information) via the operation section 7.

The DSP (signal processor) 8 performs signal processing such as equalizer processing to digital audio data. The DAC 9 D/A-converts the digital audio data into analog audio data. Each of the amplifiers 10 and 11 amplifies the analog audio data that the DAC 9 D/A-converts and outputs the amplified analog audio data to a headphone 100. The wireless module 12 is for performing wireless communication according to Bluetooth (registered trademark) standard and Wi-Fi standard. The DAP 1 can communicate with an external server via the wireless module 12. The USB I/F 13 is for performing communication according to USB standard. The DAP 1 can communicate with a personal computer via the USB I/F 13.

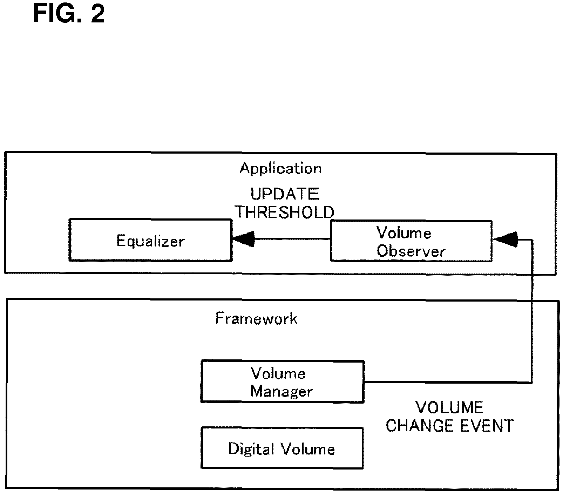

Next, processing operation of the DAP 1 in case where volume value is changed is described. Fig. 2 is a diagram illustrating a constitution of application of the DAP 1. The DAP 1 mounts Android (registered trademark) OS. When playing back music, music playback is performed according to Framework that is provided by Android (registered trademark). Digital volume and Volume Manager are included in Framework. Digital volume adjusts volume of digital audio data. Volume Manager performs management of volume such as reception of change of volume. Volume Observer and Equalizer are included in Application. Volume Observer monitors volume value of system volume. Equalizer performs equalizing processing to digital audio data.

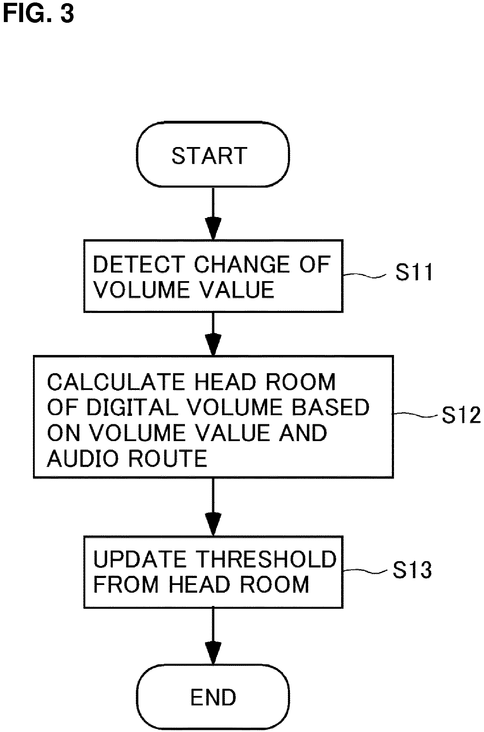

Fig. 3 is a flow chart illustrating processing operation of the DAP 1 in case where volume value is changed. When the DSP 8 detects change of volume value (S11), it calculates head room of digital volume based on volume value and audio route (S12). Next, the DSP 8 updates threshold from head room (S13).

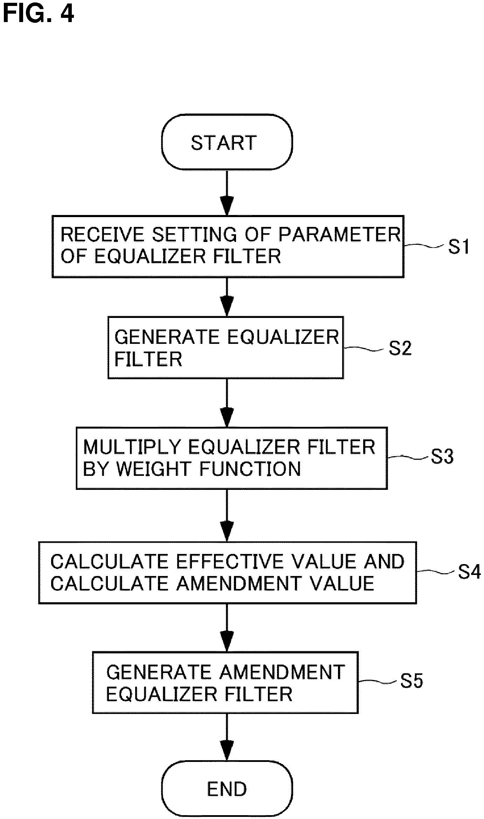

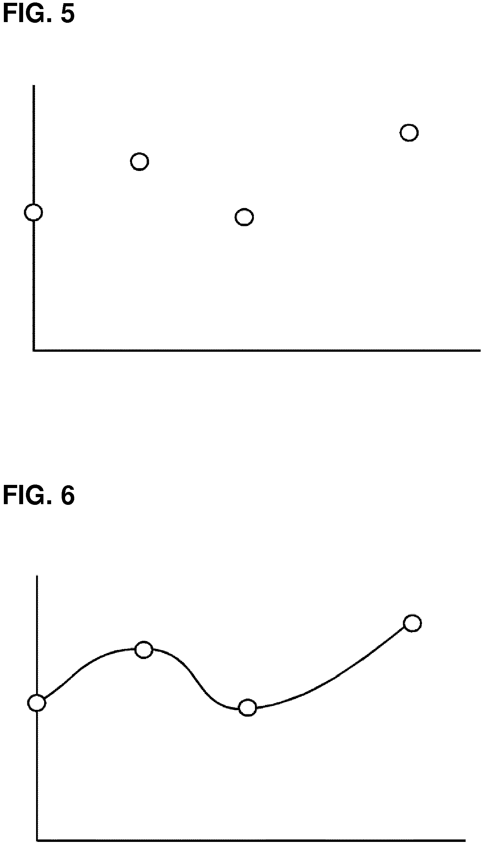

Next, processing operation in case where the DAP 1 generates an amendment equalizer filter that an equalizer filter is amended is described based on a flowchart illustrated in Fig. 4. The CPU 2 receives setting of parameter of the equalizer filter (S1). As illustrated in Fig. 5, a user can set parameter of the equalizer filter by the touch panel that is linked with the display section 6. For example, the CPU 2 receives contact position as parameter of the equalizer filter by the touch panel. Next, the DSP 8 generates the equalizer filter by interpolating parameter that the CPU 2 receives (S2). As illustrated in Fig. 6, the DSP 8 generates the equalizer filter.

Next, the DSP 8 multiplies the equalizer filter by a weight function (S3). Herein, the weight function is frequency characteristics of Programme Simulation Noise. Programme Simulation Noise is a test signal that is used for measurement in Europe sound pressure regulation (with regard to Programme Simulation Noise, see http://www.jas-audio.or.jp/jas-cms/wp-content/uploads/2013/10/201309-all.pdf page 6, fig. 5, "power spectrum distribution of Simulated program signal"). In Programme Simulation Noise, relative level of high band is lower than the other band. Fig. 5 is a diagram illustrating the equalizer filter multiplied by the weight function. As illustrated in Fig. 5, high band drops compared with the equalizer filer illustrated in Fig. 4.

Next, the DSP 8 calculates effective value and calculates amendment value (S4). First, the DSP 8 calculates first effective value that is effective value of frequency characteristics of the equalizer filter multiplied by the weight function. Concretely, the DSP 8 performs calculation of the following formula 1.

$$[\text{Formula 1}]$$

$$\text{F'rms} = \sqrt{\sum F(\omega)W(\omega) \cdot \overline{F(\omega)W(\omega)}}$$

Namely, the DSP 8 takes the square root of sum of value of each frequency of product of the equalizer filter multiplied by the weight function and conjugate complex number of the equalizer filter multiplied by the weight function. Herein, $F(\omega)$ is frequency characteristics of the equalizer filter. $W(\omega)$ is frequency characteristics of the weight function. F'rms is the first effective value.

Next, the DSP 8 calculates second effective value that is effective value of frequency characteristics of the weight function. Concretely, the DSP 8 performs calculation of the following formula 2.

[Formula 2]

$$Wrms = \sqrt{\sum W(\omega)\overline{W(\omega)}}$$

Namely, the DSP 8 takes the square root of sum of each frequency of product of the weight function and conjugate complex number of the weight function. Herein, Wrms is the second effective value.

Next, the DSP 8 calculates third effective value that is effective value of gain of the equalizer filter based on the first effective value and the second effective value. Concretely, the DSP 8 performs calculation of the following formula 3.

[Formula 3]

$$Grms = \frac{F'rms}{Wrms}$$

Namely the DSP 8 divides the first effective value by the second effective value. Herein, Grms is the third effective value.

Next, in case the third effective value is not less than the predetermined threshold, the DSP 8 calculates amendment value based on the threshold and the third effective value. Concretely, the DSP 8 performs calculation of the following formula 4.

$$Vc = \frac{Vt}{Grms}$$

Namely, the DSP 8 divides the threshold by the third effective value. Herein, Vc is the amendment value. Vt is the threshold.

Next, the DSP 8 calculates an amendment equalizer filter that the equalizer filer is amended based on the amendment value (S5). Concretely, the DSP 8 performs calculation of the following formula 5.

[Formula 5]

$$Fc(\omega) = VcF(\omega)$$

Namely, the DSP 8 multiplies the equalizer filter by the amendment value. Herein, $Fc(\omega)$ is the amendment equalizer filter.

The DSP 8 performs equalizer processing that changes frequency characteristics of the audio signal (digital audio data) based on the amendment equalizer filter.

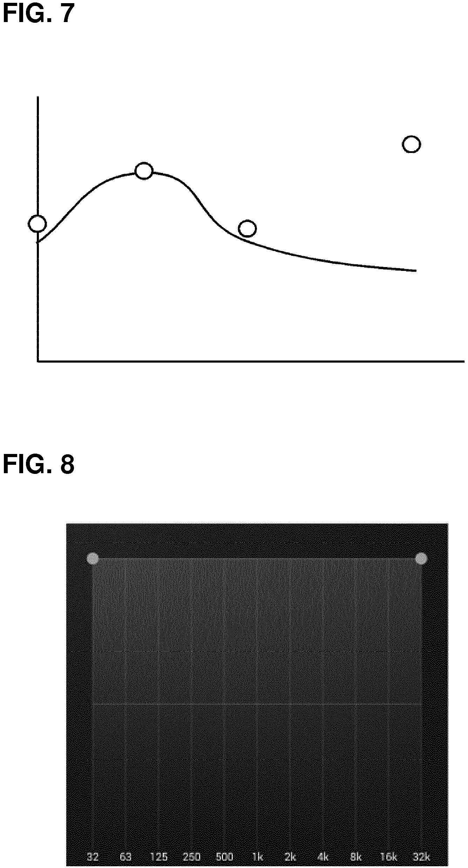

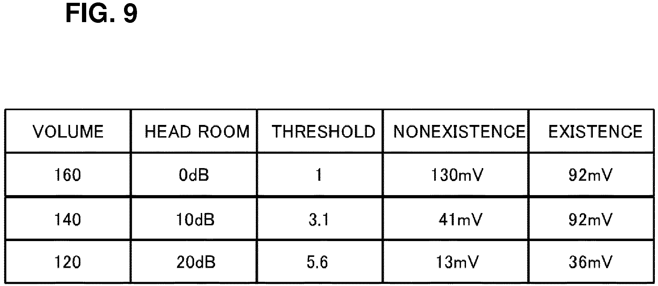

Fig. 8 is a diagram illustrating one example of an equalizer filter. Fig. 9 is a diagram illustrating effective value of output voltage of a headphone terminal. "Volume" illustrates step of system volume. "Head room" illustrates head room of system volume. "Threshold" illustrates the above described threshold. "Nonexistence" is effective value in case where equalizing processing is not performed. "Existence" is effective value in case where equalizing processing is performed. It is necessary that effective value is not more than 150 mV in Europe sound pressure regulation.

In case that step of volume is 160, the head room is 0 dB and the threshold is 1. Further, effective value of nonexistence of equalizer processing is 130 mv and effective value of existence of equalizer processing is 92 mV. In case that step of volume is 140, the head room is 10 dB and the threshold is 3.1. Further, effective value of nonexistence of equalizer processing is 41 mV and effective value of existence of equalizer processing is 92 mV. In case that step of volume is 120, the head room is 20 dB and the threshold is 5.6. Further, effective value of nonexistence of equalizer processing is 13 mV and effective value existence of equalizer processing is 36 mV.

As described above, in the present embodiment, the DSP 8 changes the threshold based on volume. Thus, amendment processing can be performed based on output level because amendment of the equalizer filter is not performed when volume is small.

Further, in the present embodiment, the DSP 8 multiplies the equalizer filter by frequency characteristics of Programme Simulation Noise as the weight function, and calculates the amendment value using the equalizer filter multiplied by frequency characteristics of Programme Simulation Noise. And, the DSP 8 calculates the amendment equalizer filter that the equalizer filter is amended based on the amendment value. Like this, an audio signal that is not more than regulation can be output by the amendment equalizer filter that is amended because Programme Simulation Noise is considered and the equalizer filter is amended using the equalizer filter multiplied by frequency characteristics of Programme Simulation Noise as the weight function even if Programme Simulation Noise is input.

The embodiment of the present invention is described above, but the mode to which the present invention is applicable is not limited to the above embodiment and can be suitably varied without departing from the scope of the present invention.

In the above embodiment, Programme Simulation Noise is used as the test signal. Not limited to this, the other signal may be used.

In the above embodiment, an equalizer program is integrated into the music reproducing program P. Not limited to this, a music reproducing program that reproduces music files and the equalizer program may be the other program.

In above embodiment, case where the music reproducing program P is installed into the DAP 1 is described. Not limited to this, a smartphone, a tablet PC, a feature phone, a portable media player, or a potable game machine may be used as a device that functions an equalizer device.

INDUSTRIAL APPICABILITY

The present invention can be suitably employed in an equalizer device and an equalizer program that perform equalizer processing that changes frequency characteristics of an audio signal.

LIST OF REFFERENCE NUMERALS

1 DAP (equalizer device)
2 CPU (controller)
6 Display section
7 Operation section
8 DSP (signal processor)
P Music reproducing program (equalizer program)

**Claims**

1. An equalizer device comprising:

   a signal processor configured to
   calculate amendment value based on threshold and effective value in case that the effective value of gain of equalizer information is not less than predetermined threshold,
   calculate amendment equalizer information that the equalizer information is amended based on the amendment value, and
   change frequency characteristics of an audio signal based on the amendment equalizer information,
   wherein the signal processor changes the threshold based on volume.

2. The equalizer device according to claim 1,
   wherein the signal processor
   multiplies the equalizer information by a test signal as a weight function, calculates first effective value that is effective value of frequency characteristics of the equalizer information multiplied by the test signal,
   calculates second effective value that is effective value of frequency characteristics of the test signal, and
   calculates third effective value that is effective value of gain of the equalizer information based on the first effective value and the second effective value.

3. The equalizer device according to claim 2,
   wherein the signal processor calculates the amendment value by dividing the threshold by the third effective value.

4. The equalizer device according to claim 2 or 3,
   wherein the signal processor calculates the third effective value by dividing the first effective value by the second effective value.

**5.** The equalizer device according to any one of claims 2 to 4,
wherein the signal processor calculates the amendment equalizer information by multiplying the equalizer information by the amendment value.

**6.** The equalizer device according to any one of claims 2 to 5,
wherein the signal processor calculates the first effective value by taking the square root of sum of value of each frequency of product of the equalizer information multiplied by the test signal and conjugate complex number of the equalizer information multiplied by the test signal.

**7.** The equalizer device according to any one of claims 2 to 6, wherein the signal processor calculates the second effective value by taking the square root of sum of each frequency of product of the test signal and conjugate complex number of the test signal.

**8.** The equalizer device according to any one of claims 2 to 7,
wherein the test signal is Programme Simulation Noise.

**9.** The equalizer device according to any one of claims 2 to 8 further comprising, a controller that receives setting of parameter of the equalizer information, wherein
the signal processor generates the equalizer information by interpolating the parameter that the controller receives.

**10.** An equalizer program that allows a signal processor of a computer
to calculate amendment value based on threshold and effective value in case that the effective value of gain of equalizer information is not less than predetermined threshold,
to calculate amendment equalizer information that the equalizer information is amended based on the amendment value, and
to change frequency characteristics of an audio signal based on the amendment equalizer information, and
to change the threshold based on volume.

# FIG. 1

1

DAP

2 — CPU

3 — ROM

4 — RAM

5 — STORAGE SECTION

P — MUSIC REPRODUCING PROGRAM

6 — DISPLAY SECTION

7 — OPERATION SECTION

8 — DSP

9 — DAC

10 — AMPLIFIER

11 — AMPLIFIER

12 — WIRELESS MODULE

13 — USB I/F

100 — HEADPHONE

# FIG. 2

Application

UPDATE
THRESHOLD

Equalizer

Volume
Observer

Framework

Volume
Manager

VOLUME
CHANGE EVENT

Digital Volume

# FIG. 3

```
                    ┌─────────────┐
                    │    START    │
                    └──────┬──────┘
                           │
                           ▼
              ┌────────────────────────┐
              │ DETECT CHANGE OF       │ ─── S11
              │ VOLUME VALUE           │
              └───────────┬────────────┘
                          │
                          ▼
              ┌────────────────────────┐
              │ CALCULATE HEAD ROOM    │
              │ OF DIGITAL VOLUME BASED│ ─── S12
              │ ON VOLUME VALUE AND    │
              │ AUDIO ROUTE            │
              └───────────┬────────────┘
                          │
                          ▼
              ┌────────────────────────┐
              │ UPDATE THRESHOLD       │ ─── S13
              │ FROM HEAD ROOM         │
              └───────────┬────────────┘
                          │
                          ▼
                    ┌─────────────┐
                    │     END     │
                    └─────────────┘
```

# FIG. 4

START

↓

RECEIVE SETTING OF PARAMETER OF EQUALIZER FILTER — S1

↓

GENERATE EQUALIZER FILTER — S2

↓

MULTIPLY EQUALIZER FILTER BY WEIGHT FUNCTION — S3

↓

CALCULATE EFFECTIVE VALUE AND CALCULATE AMENDMENT VALUE — S4

↓

GENERATE AMENDMENT EQUALIZER FILTER — S5

↓

END

**FIG. 5**

**FIG. 6**

## FIG. 7

## FIG. 8

# FIG. 9

| VOLUME | HEAD ROOM | THRESHOLD | NONEXISTENCE | EXISTENCE |
|--------|-----------|-----------|--------------|-----------|
| 160 | 0dB | 1 | 130mV | 92mV |
| 140 | 10dB | 3.1 | 41mV | 92mV |
| 120 | 20dB | 5.6 | 13mV | 36mV |

Europäisches
Patentamt

European
Patent Office

Office européen
des brevets

# EUROPEAN SEARCH REPORT

Application Number

EP 17 18 4537

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2015/130283 A1 (NUANCE COMMUNICATIONS INC [US]) 3 September 2015 (2015-09-03) <br> * page 3, line 24 - page 4, line 17 * <br> * page 7, line 20 - page 13, line 11; figures 3-5 * <br> ----- | 1-5,8,10 | INV. <br> H03G5/16 <br> H03G9/14 <br><br> ADD. <br> H04R5/04 |
| A | US 2008/013751 A1 (HISELIUS PER [SE]) 17 January 2008 (2008-01-17) <br> * paragraph [0048] - paragraph [0067]; figures 1-9 * <br> ----- | 1-10 | |
| A | WO 2015/128696 A1 (SONY CORP [JP]) 3 September 2015 (2015-09-03) <br> * paragraph [0020] - paragraph [0031]; figures 1-4 * <br> ----- | 1-10 | |

TECHNICAL FIELDS
SEARCHED        (IPC)

H03G
H04R

The present search report has been drawn up for all claims

| Place of search | Date of completion of the search | Examiner |
|---|---|---|
| Munich | 12 December 2017 | Joder, Cyril |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 17 18 4537

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2017

| Patent document cited in search report | | Publication date | Patent family member(s) | | Publication date |
|---|---|---|---|---|---|
| WO 2015130283 | A1 | 03-09-2015 | EP | 3103204 A1 | 14-12-2016 |
| | | | US | 2017011753 A1 | 12-01-2017 |
| | | | WO | 2015130283 A1 | 03-09-2015 |
| US 2008013751 | A1 | 17-01-2008 | CN | 101490952 A | 22-07-2009 |
| | | | EP | 2047595 A1 | 15-04-2009 |
| | | | US | 2008013751 A1 | 17-01-2008 |
| | | | WO | 2008010029 A1 | 24-01-2008 |
| WO 2015128696 | A1 | 03-09-2015 | CN | 106031030 A | 12-10-2016 |
| | | | EP | 3111557 A1 | 04-01-2017 |
| | | | US | 2016268989 A1 | 15-09-2016 |
| | | | WO | 2015128696 A1 | 03-09-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016076539 A

- JP 2012084949 A